# FASCICULE DE BREVET EUROPEEN

(11) **EP 1 927 129 B1**
(45) Date de publication et mention de la délivrance du brevet: **13.03.2019**
(21) Numéro de dépôt: 06831204.0
(22) Date de dépôt: 20.09.2006
(51) Int. Cl.: H01L 21/288

(54) **PROCEDE D'ELECTRODEPOSITION DESTINE AU REVETEMENT D'UNE SURFACE D'UN SUBSTRAT PAR UN METAL**
ELEKTROPLATTIERUNGSVERFAHREN ZUR BESCHICHTUNG EINER SUBSTRATOBERFLÄCHE MIT EINEM METALL
ELECTROPLATING METHOD FOR COATING A SUBSTRATE SURFACE WITH A METAL

(30) Priorité: 20.09.2005 FR 0509572
(43) Date de publication de la demande: 04.06.2008
(73) Titulaire: aveni, 91300 Massy (FR)
(72) Inventeur: MONCHOIX, Hervé, F-38330 Saint Isnier (FR); RAYNAL, Frédéric, F-75012 Paris (FR); DAVIOT, Jérôme, F-92160 Antony (FR); GONZALEZ, José, F-75019 Paris (FR)
(74) Mandataire: Chantraine, Sylvie Hélène
(86) Numéro de dépôt international: PCT/FR2006/050915
(87) Numéro de publication internationale: WO 2007/034117

(56) Documents cités:
- US-A1- 2001 042 689
- US-A1- 2005 006 245
- US-A1- 2005 199 502
- US-B1- 6 309 969
- US-B1- 6 409 903

## Description

La présente invention concerne généralement un procédé de revêtement par électrodéposition d'une surface d'un substrat par un métal et plus particulièrement le cuivre et en particulier d'une surface constituée d'un matériau électriquement résistif.

L'invention trouve notamment application dans le domaine de la microélectronique pour la fabrication d'éléments d'interconnexion dans des circuits intégrés. Elle trouve également application dans d'autres domaines de l'électronique pour la fabrication d'éléments d'interconnexion dans des circuits imprimés (dénommés « Printed Circuit Board » ou « Printed Wire Board » en anglais) ou celle d'éléments passifs, tels que les inductances, ou électromécaniques dans des circuits intégrés ou des microsystèmes (dénommés « Micro Electro Mechanical Systems » en anglais).

Par électrodéposition on entend ici un procédé qui permet de recouvrir une surface d'un substrat par un revêtement métallique ou organométallique, dans lequel le substrat est polarisé électriquement et mis au contact d'un liquide contenant des précurseurs dudit revêtement métallique ou organométallique, de manière à former ledit revêtement. Lorsque le substrat est conducteur de l'électricité, l'électrodéposition est par exemple réalisée par passage d'un courant entre le substrat à revêtir constituant une électrode (la cathode dans le cas d'un revêtement métallique ou organométallique) et une seconde électrode (l'anode) dans un bain contenant une source de précurseurs du matériau de revêtement (par exemple des ions métalliques dans le cas d'un revêtement métallique) et éventuellement divers agents destinés à améliorer les propriétés du revêtement formé (régularité et finesse du dépôt, résistivité, etc.), éventuellement en présence d'une électrode de référence. Par convention internationale le courant et la tension passant ou appliqué au substrat d'intérêt, c'est-à-dire à la cathode du circuit électrochimique, sont négatifs. Dans l'ensemble de ce texte, lorsque ces courants et tensions sont mentionnés par une valeur positive, il est implicite que cette valeur représente la valeur absolue dudit courant ou de ladite tension.

L'électrodéposition de cuivre est notamment utilisée dans le domaine de la microélectronique pour la fabrication d'éléments d'interconnexion dans des circuits intégrés. La bonne conductivité électrique du cuivre et sa résistance élevée au phénomène d'électromigration, c'est-à-dire la faible migration des atomes de cuivre sous l'effet de la densité de courant électrique susceptible de déformer significativement le conducteur et d'être une cause importante de défaillance, en font en particulier un matériau de choix pour la fabrication d'interconnexions métalliques pour des circuits intégrés présentant des dimensions de gravure de plus en plus fines.

Les circuits intégrés sont généralement fabriqués par formation de dispositifs semiconducteurs actifs, notamment des transistors, à la surface de plaquettes de silicium (dénommées "Wafers" en anglais), lesdits dispositifs semiconducteurs étant reliés entre eux par un système d'interconnexions métalliques formé de "lignes" et de "contacts" encore dénommés "vias" disposés en niveaux superposés et obtenus par remplissage respectivement de "tranchées" et de "puits" encore dénommés "trous d'interconnexion" pratiqués dans les couches diélectriques.

Le cuivre étant difficile à graver et présentant un haut pouvoir de diffusion dans de nombreux matériaux, les éléments d'interconnexion sont généralement réalisés par une succession d'étapes comportant :
- le dépôt d'une couche diélectrique isolante ;
- la gravure des motifs d'interconnexion dans ladite couche diélectrique ;
- le dépôt d'une couche barrière (généralement constituée de tantale, nitrure de titane, nitrure de tantale, nitrure ou carbure de tungstène, par exemple) servant à empêcher la migration du cuivre ;
- le remplissage des lignes et des trous d'interconnexion par du cuivre ; et
- l'élimination du cuivre en excès par polissage mécano-chimique.

Cette succession d'étapes est connue sous le nom de "procédé Damascène", lequel a été décrit par exemple dans : Chang, C. Y. and Sze, S. M., "ULSI Technology" McGraw-Hill, New York, (1996), pages 444-445.

La couche barrière présente généralement une résistance trop élevée pour permettre, par voie électrochimique, un dépôt de cuivre homogène ou uniforme à l'échelle de la plaquette, phénomène connu de l'homme de l'art sous le terme de chute ohmique. La résistance élevée de la couche barrière résulte à la fois de la résistivité élevée des matériaux la constituant (généralement nitrures métalliques) et de sa faible épaisseur (généralement de quelques nm à quelques dizaines de nm selon la génération de circuits intégrés) laquelle épaisseur est imposée par la faible dimension des motifs d'interconnexion.

De ce fait, il est généralement nécessaire, préalablement à l'étape d'électrodéposition du cuivre, de recouvrir la couche barrière - par une méthode non électrochimique - d'une mince couche de cuivre métallique, appelée couche de germination ("seed layer" en anglais). Cette couche de germination, comme la couche barrière, est actuellement réalisée par des procédés de dépôt physique ou chimique à partir d'une phase vapeur (PVD ou "Physical Vapor Deposition et CVD ou "Chemical Vapor Déposition" en anglais, respectivement).

Compte tenu des dimensions critiques des lignes et des trous d'interconnexion des circuits intégrés actuels, et de leur évolution vers des dimensions de plus en plus réduites, l'épaisseur des couches de germination de cuivre est à l'heure actuelle de l'ordre de 30 nm, et devrait rapidement évoluer vers 10 nm ou moins.

Le dépôt chimique en phase vapeur (CVD) permet d'obtenir une couche de cuivre conforme, c'est-à-dire épousant fidèlement la topographie de la surface à revêtir, et ceci pour une large gamme de facteurs de forme (« aspect ratio » en anglais). Cependant, les couches de cuivre formées par dépôt chimique en phase vapeur présentent une adhérence médiocre sur les barrières de diffusion. Ceci limite en pratique l'intérêt de ce type de procédé dans la mesure où une forte adhérence entre le cuivre et la barrière est requise afin d'assurer la fiabilité des structures constituant les interconnexions.

De plus, les procédés utilisant un dépôt chimique en phase vapeur sont relativement coûteux en raison du prix élevé des consommables (précurseurs), de l'équipement nécessaire à leur mise en oeuvre et de leur faible rendement.

Le dépôt physique en phase vapeur (PVD) est actuellement préféré d'un point de vue industriel dans la mesure où il permet de revêtir des surfaces ayant une résistivité élevée avec une adhérence du cuivre sur la barrière bien meilleure que celle obtenue avec les procédés de type CVD.

L'épaisseur du revêtement déposé par PVD est directement proportionnelle à l'angle solide vu de la surface à revêtir. De ce fait, les parties de la surface présentant des angles saillants sont recouvertes d'une couche plus épaisse que les parties de la surface présentant des angles rentrants. Il en résulte que les couches de germination de cuivre formées par dépôt physique en phase vapeur ne sont pas conformes, et ne présentent donc pas une épaisseur uniforme en tout point de la surface du substrat. On observe en particulier des phénomènes dits de surplomb ou d'ombre (ou d' « overhang » en anglais) aux arêtes supérieures des tranchées ou des vias, allant jusqu'à obstruer leur ouverture, et rendant impossible leur remplissage ultérieur. Par ailleurs, les flancs des tranchées et des vias peuvent être recouverts d'une épaisseur insuffisante de couche de germination, provoquant alors un remplissage ultérieur imparfait présentant des défauts de matière (appelées « voids » en anglais). De plus, la couche de germination réalisée sur les flancs des motifs présente par nature une adhérence différente de celle déposée sur la surface plane du substrat (haut et fond des tranchées et des vias). Ceci peut conduire à des performances de fiabilité, telles que la résistance à l'électromigration, amoindries. En d'autres termes, le défaut de conformité ne se révèle pas seulement par des différences d'épaisseur ; des défauts de continuité et d'adhérence de la couche sur les flancs des tranchées et des vias peuvent aussi en résulter.

Ces inconvénients rendent très délicat l'emploi de la technologie PVD dans les générations avancées de circuits intégrés où les dimensions transversales des tranchées et des vias sont très faibles (de l'ordre de quelques dizaines de nanomètres) et où les facteurs de forme peuvent être importants.

Dans ce contexte, la technique d'électrodéposition présentée ici constitue une alternative avantageuse aux procédés de dépôt chimique ou physique en phase vapeur, ainsi qu'aux techniques d'électrodéposition de métaux plus traditionnelles, qui ne peuvent pas opérer sur des substrats résistifs.

En effet, l'électrodéposition traditionnelle, qui consiste à appliquer un courant en général continu au substrat plongé dans un bain d'ions métalliques ne peut être appliquée qu'aux seules surfaces suffisamment conductrices c'est-à-dire présentant typiquement une résistance carrée inférieure à quelques ohm/carré environ, ce qui n'est pas le cas des couches formant barrière de diffusion au cuivre pour les technologies les plus avancées, dont la résistance carrée est couramment de plusieurs dizaines d'ohm/carré à plusieurs centaines d'ohm/carré et peut être de plusieurs dizaines de milliers d'ohm/carré.

La résistance carrée (« sheet résistance » en anglais) est une grandeur utilisée par l'homme de l'art mesurant la résistance électrique des couches minces. Elle est exprimée en ohm/carré et elle est équivalente à la résistivité pour un système bidimensionnel, c'est-à-dire dans lequel le courant circule dans le plan de la couche et non dans un plan perpendiculaire à cette couche. Mathématiquement, on obtient la valeur de la résistance carrée en divisant la résistivité du matériau (exprimée en ohm.m ou micro-ohm.cm) constitutif de la couche par l'épaisseur de cette couche (exprimée en m ou nm).

A ce jour, l'électrodéposition traditionnelle de cuivre est principalement utilisée pour le remplissage des tranchées et des puits dans le procédé Damascène, par application d'un courant continu à un wafer préalablement couvert d'une couche de germination et plongé dans un bain acide de sulfate de cuivre contenant des additifs. Ce procédé de remplissage des tranchées et puits par du cuivre métallique est notamment décrit dans Rosenberg et al., in "Copper metalization for high performance silicon technology", Ann. Rev. Mater. Sci (2000), 30, 229-62.

Une utilisation de l'électrodéposition de cuivre sur une couche de germination de cuivre pour le remplissage des tranchées et des puits a également été décrite dans le brevet US 6 893 550 incorporé ici par référence.

Le procédé d'électrodéposition décrit dans le document US 6 893 550 est essentiellement caractérisé :
- d'une part, en ce qu'il fait appel à un bain d'électrodéposition dont la composition chimique spécifique comprend au moins un acide, de préférence l'acide sulfurique, au moins un ion halogénure, de préférence chlorure et une combinaison d'agents chimiques susceptibles d'accélérer ou de ralentir la formation du revêtement ; et
- d'autre part, en ce qu'il consiste à modifier la densité du courant appliqué selon des séquences prédéterminées.

Une électrodéposition de cuivre a également été préconisée, notamment par le brevet US 6 811 675 pour combler d'éventuels vides dans la couche de germination ou pour réparer cette couche ("seed repair" ou "seed enhancement" en anglais).

Dans un mode de réalisation préféré décrit dans ce document antérieur, on réalise dans une première étape, de préférence par un procédé de dépôt physique à partir d'une phase vapeur, une couche de germination en cuivre « ultra fine » non uniforme (épaisseur de l'ordre de 20 nanomètres) puis dans une deuxième étape, on améliore la conformité de la couche par électrodéposition à l'aide d'une solution alcaline (dont le pH est supérieur à 9) d'électrodéposition qui comprend du sulfate de cuivre, un agent complexant du cuivre, de préférence l'acide citrique, et éventuellement de l'acide borique pour améliorer la brillance du revêtement et/ou du sulfate d'ammonium pour réduire la résistivité du revêtement. La densité du courant continu appliqué lors de l'électrodéposition est comprise entre 1 mA/ cm² et 5 mA/ cm².

Il est indiqué dans ce document antérieur que ce procédé d'électrodéposition peut-être également utilisé pour réaliser directement une couche de germination en cuivre, mais cette possibilité n'est illustrée par aucun exemple et parait difficilement réalisable, en raison des densités de courant élevées mentionnées dans ce document.

Dans le document US 6 409 903, le revêtement par électrodéposition d'un substrat comprenant une couche de germination déjà constituée vise à résoudre le problème des « brûlures perforantes » (burn-through) en imposant une tension de cellule inférieure à un certain seuil (V(h)).
Les procédés d'électrodéposition décrits dans les documents US 6 309 969 et US 2005/199502 permettent le dépôt de couches de germination du cuivre sur les substrats barrière à la diffusion du cuivre. Des compositions d'électrodeposition contenant un complexe du cuivre avec des citrates ou des borates en milieu acide ont été décrites dans le document US2005/0006245.

Dans ces conditions, la présente invention a pour but de résoudre le nouveau problème technique consistant en la fourniture d'un procédé de revêtement par électrodéposition d'une surface d'un substrat par un métal permettant en particulier de réaliser des couches de germination en cuivre continues et conformes, d'une épaisseur de l'ordre de 10 nm ou moins et présentant une excellente adhésion sur des surfaces de barrière de diffusion pouvant avoir une résistivité élevée jusqu'à quelques méga ohm/carré.

Il a été découvert, et ceci constitue le fondement de la présente invention, qu'il était possible de résoudre ce problème technique d'une façon relativement simple et utilisable à l'échelle industrielle, en utilisant un bain d'électrodéposition spécifique et en contrôlant les conditions de mise en contact de la surface à revêtir avec le bain d'électrodéposition préalablement à la formation du revêtement et les conditions de séparation de cette surface dudit bain après formation du revêtement.

Ainsi, la présente invention a généralement pour objet un procédé de revêtement par électrodéposition d'une surface d'un substrat par du cuivre, selon la revendication 1.

Il a été observé, de façon tout à fait inattendue, qu'il était possible, avec les bains d'électrodéposition précités, d'améliorer l'adhérence entre la couche de revêtement de cuivre réalisée par électrodéposition et la couche barrière, en mettant la surface à revêtir au contact du bain d'électrodéposition sans polarisation électrique, c'est-à-dire sans imposer de courant électrique ou de potentiel électrique par rapport à une contre-électrode ou par rapport à une électrode de référence à cette surface, préalablement à l'étape d'électrodéposition.

Une amélioration encore plus importante de cette adhérence a été observée lorsque la surface du substrat à revêtir est maintenue au contact du bain d'électrodéposition pendant une durée d'au moins 5 secondes après cette mise en contact et toujours préalablement à l'étape d'électrodéposition.

Il a en outre été observé, de façon surprenante, qu'il était possible d'obtenir une couche de germination présentant une conductivité compatible avec les procédés de remplissage par électrodéposition, en maintenant sous polarisation électrique la surface revêtue, de préférence pendant une durée comprise entre 1 et 10 secondes, après sa séparation du bain d'électrodéposition.

Ce sont donc les étapes dites d'« entrée à froid » et de « sortie à chaud » qui constituent les étapes caractéristiques essentielles du procédé conforme à la présente invention.

L'étape de formation du revêtement de cuivre est réalisée d'une façon relativement classique, mais il a été observé qu'à la différence des procédés décrits dans l'état de la technique et notamment dans le brevet US 6 811 675 le niveau de courant nécessaire pour former le revêtement est beaucoup plus faible (au minimum cinq fois plus faible que la valeur moyenne mentionnée dans ce brevet antérieur, et en tout état de cause en dehors des fenêtres de procédé y mentionnées).

L'« entrée à chaud », c'est-à-dire sous polarisation, est la pratique standard dans les procédés de dépôt électrochimique du cuivre pour le remplissage des tranchées et puits. En effet, la solution d'électrodéposition étant généralement acide, celle-ci est susceptible de provoquer une attaque chimique de la couche de germination et par conséquent d'empêcher l'électrodéposition, ce que l'on souhaite éviter.

Au cours de l'étape d'« entrée à froid » du procédé selon l'invention, la surface du substrat à revêtir est de préférence maintenue au contact du bain d'électrodéposition pendant une durée d'au moins 5 secondes.

Il a été observé que l'ajustement de ce paramètre dans la réalisation de la seule couche de germination permet, de façon surprenante, d'améliorer l'adhésion de l'ensemble « couche de germination / couche de remplissage ou cuivre épais ou couche épaisse », c'est-à-dire l'adhérence « opérationnelle » de l'assemblage pour lequel la couche de germination est réalisée. En effet, même s'il est en général difficile de mesurer directement l'adhésion d'une couche de germination seule, notamment du fait de sa faible épaisseur, on observe que l'adhésion des couches de germination réalisées selon la présente invention est manifestement très élevée. Cependant, c'est après réalisation d'une couche épaisse de cuivre (d'environ 500 nanomètres à 1 micron, voire plus) qu'il est plus aisé et utile d'évaluer l'énergie d'adhésion de l'ensemble « couche de germination / couche de remplissage ou cuivre épais ou couche épaisse » sur la couche barrière, qui est la propriété opérationnelle d'intérêt que l'on cherche effectivement à optimiser. On peut par exemple évaluer cette adhésion par pelage (« peeling » en anglais) d'un ruban adhésif collé sur la surface supérieure de l'assemblage par exemple par l'emploi d'une machine d'essai ou de traction. L'adhésion ainsi mesurée, ou énergie d'interface exprimée en J/m², caractérise globalement à la fois l'adhérence de la couche de germination sur la barrière et celle de la couche épaisse de cuivre sur la couche de germination. Elle ne donne pas de renseignement précis sur l'une ou l'autre interface, mais permet de quantifier la propriété opérationnelle recherchée, à savoir la solidité de l'interface cuivre/barrière. Dans la suite, on parlera ainsi indifféremment de l'adhésion de la couche de germination, de l'adhésion de la couche épaisse de cuivre sur la couche de germination, ou de la solidité de l'interface cuivre/barrière après remplissage.

Il a également été observé que si la durée de l'étape d'entrée à froid est inférieure à 5 secondes, l'adhérence de la couche de cuivre au substrat, bien qu'améliorée par comparaison à une entrée sous polarisation, peut rester dans certains cas insuffisante notamment pour la réalisation d'une couche de germination de cuivre déposée directement au contact d'une couche barrière d'un élément d'interconnexion de circuits intégrés.

En revanche, si la durée de cette étape est supérieure ou égale à 5 secondes, de préférence comprise entre 10 et 60 secondes, et de préférence encore d'environ 10 à 30 secondes, l'énergie d'interface mesurée par la force de pelage est sensiblement égale voire supérieure à celle obtenue par des procédés de pulvérisation (supérieure à 10 J/m²).

Il n'y a pas de limitation particulière concernant la durée maximale de cette étape, mais dans les conditions expérimentales mises en oeuvre, il n'a pas été observé d'amélioration sensible de l'adhésion au-delà d'une durée d'environ 60 secondes.

Au cours de l'étape de « sortie à chaud » du procédé selon l'invention, la surface du substrat revêtue par le cuivre est séparée du bain d'électrodéposition sous polarisation électrique de préférence pendant une durée comprise entre 1 et 10 secondes, de préférence pendant une durée d'environ 1 à 5 secondes.

Il a été observé que dans le cas d'une « sortie à froid », c'est-à-dire sans polarisation (c'est-à-dire encore lorsque la polarisation électrique du substrat est interrompue avant de procéder à la sortie dudit substrat du bain d'électrodéposition), la résistance du revêtement de cuivre reste très voisine de celle de la couche barrière, bien qu'un dépôt électrochimique classique de cuivre de remplissage soit parfois possible sur un tel revêtement.

En revanche, il a été observé d'une façon inattendue, qu'une « sortie à chaud » permettait d'obtenir une couche de germination extrêmement fine (10 nm), présentant une conductivité électrique suffisante pour permettre une étape ultérieure de remplissage par dépôt électrochimique de cuivre selon des procédés connus de l'homme de l'art.

L'étape de « sortie à chaud » est avantageusement réalisée en mode potentiostatique, c'est-à-dire en maintenant à une valeur fixe le potentiel électrique du wafer mesuré soit par rapport à la contre-électrode du circuit, soit par rapport à une électrode de référence, de préférence au même niveau de tension que lors de l'étape de dépôt du revêtement lorsque celle-ci est également réalisée en mode potentiostatique.

La combinaison d'une étape d'entrée à froid et de sortie à chaud dans le procédé conforme à l'invention permet d'obtenir dans des conditions facilitées et reproductibles une meilleure adhésion de l'ensemble « couche de germination/cuivre de remplissage ».

L'étape de formation du revêtement par électrodéposition est conduite pendant une durée suffisante pour former le revêtement souhaité. Cette durée peut être facilement déterminée par l'homme du métier, la croissance du film étant fonction de la charge qui est égale à l'intégrale temporelle du courant électrique passé dans le circuit pendant le temps du dépôt (loi de Faraday).

Au cours de l'étape de formation du revêtement, la surface à revêtir est polarisée, soit en mode galvanostatique (courant imposé fixe), soit en mode potentiostatique (potentiel imposé et fixe, éventuellement par rapport à une électrode de référence), soit encore en mode pulsé (en courant ou en tension).

Une combinaison de ces étapes est également possible comme par exemple une étape en mode potentiostatique suivie d'une étape en mode galvanostatique.

D'une façon générale, un revêtement satisfaisant peut être obtenu par polarisation en mode galvanostatique de préférence dans une gamme de courant de 0,1 mA/cm² (milli-Ampère par centimètre carré) à 5 mA/cm², et plus particulièrement de 0,1 mA/cm² à 1 mA/cm².

Un revêtement satisfaisant peut également être obtenu par polarisation en mode potentiostatique, en imposant une tension de cellule de manière à ce que le courant de cellule résultant soit dans la même gamme de courant qu'indiquée précédemment. Bien que la tension de cellule dépende en particulier de paramètres de conception de la cellule tels que la distance à la contre-électrode ou la présence d'une membrane, elle sera facilement déterminée par l'homme de l'art en mesurant et en ajustant le courant obtenu pour un potentiel et une configuration donnés.

Un revêtement satisfaisant peut encore être obtenu par polarisation en mode pulsé, de préférence de manière à imposer des créneaux de tension.

D'une façon générale, cette étape peut être réalisée de manière à imposer des créneaux de tension correspondants à un courant par unité de surface maximum dans une gamme de 0,1 mA/cm² à 5 mA/cm², et plus particulièrement de 0,1 mA/cm² à 1 mA/cm² et à un courant par unité de surface minimum dans une gamme de 0 mA/cm² à 0,5 mA/cm², et plus particulièrement de 0 mA/cm² à 0,1 mA/cm².

Selon une caractéristique particulière, la durée de polarisation à la tension maximum peut être comprise entre 0,15 et 5 secondes, par exemple de l'ordre de deux secondes pour une tension correspondant à un courant par unité de surface maximum de l'ordre de 0,5 mA/cm², tandis que la durée de polarisation à la tension minimum peut être comprise entre 0,15 et 7 secondes, par exemple de l'ordre de 3 secondes pour une tension correspondant à un courant par unité de surface minimum de l'ordre de 0,05 mA/cm².

Le nombre de cycles à réaliser au cours de cette étape dépend de l'épaisseur souhaitée du revêtement.

D'une façon générale l'homme du métier déterminera aisément le nombre de cycles à réaliser sachant que dans les conditions générales précitées, et illustrées par les exemples de réalisation, il a été observé que la vitesse de dépôt est d'environ 0,1 nm par cycle.

Ce dernier mode de mise en oeuvre de l'invention a permis en particulier de réaliser des couches de germination de cuivre sur des substrats très résistifs, dont la résistance carrée peut atteindre 100 000 ohm/carré, voire même quelques méga ohm/carré.

Le bain (ou composition) d'électrodéposition utilisé dans le procédé conforme à la présente invention comporte en solution dans un solvant, une source d'ions du cuivre et un mélange d'agent complexants du cuivre spécifique, de préférence dans un rapport molaire particulier entre le cuivre et les agents complexants, et ce bain doit présenter un pH inférieur à 7.

On a en particulier observé d'excellents résultats lorsque dans le bain d'électrodéposition :
- le rapport molaire entre le cuivre et les agents complexants est compris entre 0,1 et 2,5 ; de préférence entre 0,3 et 1,3 ;
- le pH de ladite composition est inférieur à 7, de préférence compris entre 3,5 et 6,5.

Bien qu'il n'y ait pas de restriction de principe sur la nature du solvant (pourvu qu'il solubilise suffisamment les espèces actives de la solution et n'interfère pas avec l'électrodéposition), il s'agira de préférence d'eau ou d'une solution hydroalcoolique.

Il a été constaté que d'excellents résultats pouvaient être obtenus avec les agents complexants capable d'être adsorbés sur une surface métallique en conduisant à des couches ordonnées. De tels agents, qui constituent les agents complexants du cuivre selon l'invention, sont la pyridine et la 2, 2' bipyridine pris en mélanges, en particulier des mélanges dans lesquels le rapport molaire entre la pyridine et la 2,2' bipyridine est compris entre 5:1 et 1:5, de préférence entre 3:1 et 1:1, de préférence encore voisin de 2:1.

D'une façon générale, la composition d'électrodéposition comprend une source d'ions du cuivre, en particulier d'ions cuivriques Cu2+.

Avantageusement, la source d'ions du cuivre précitée est un sel de cuivre tel qu'en particulier le sulfate de cuivre, le chlorure de cuivre, le nitrate de cuivre, l'acétate de cuivre, de préférence le sulfate de cuivre.

Selon une caractéristique particulière, la source d'ions du cuivre est présente au sein de la composition d'électrodéposition en une concentration comprise entre 0,4 et 40 mM, de préférence entre 0,4 et 18 mM et de préférence encore entre 0,4 et 15 mM.

D'excellents résultats ont été obtenus avec des compositions dans lesquelles la source d'ions du cuivre est présente en une concentration comprise entre 0,5 et 4 mM.

Selon un mode de réalisation préféré, dans la composition d'électrodéposition utilisée dans le procédé selon l'invention, le rapport molaire entre la source d'ions du cuivre et les agents complexants du cuivre est compris entre 0,1 et 2,5, de préférence entre 0,3 et 1,3.

D'une façon générale, cette composition d'électrodéposition présente avantageusement un pH inférieur à 7, de préférence compris entre 3,5 et 6,5.

Le pH de la composition peut éventuellement être ajusté dans la gamme de pH précitée au moyen d'un tampon tel que l'un de ceux décrits dans : « Handbook of chemistry and physics - 84th edition » David R. Lide, CRC Press.

Une composition d'électrodéposition actuellement préférée comprend, en solution aqueuse :
- du sulfate de cuivre, en une concentration comprise entre 0,4 et 40 mM, de préférence entre 0,4 et 18 mM et de préférence encore entre 0,4 et 15 mM ;
- un mélange de pyridine et de 2,2' bipyridine en tant qu'agents complexants du cuivre ;
- le rapport molaire entre le cuivre et les agents complexants étant compris entre un 0,3 et 1,3 ;
- le pH de ladite composition étant inférieur à 7, de préférence compris entre 3,5 et 6,5.

Le procédé conforme à la présente invention est particulièrement utile pour la réalisation d'une couche de germination de cuivre présentant une épaisseur très faible, par exemple de l'ordre de 10 nm ou moins, sur une surface formant barrière de diffusion au cuivre.

Selon une caractéristique particulière, la surface formant barrière de diffusion au cuivre comprend au moins l'un des matériaux choisis parmi le nitrure de tantale, le tantale, le ruthénium, le cobalt, le tungstène, le nitrure de titanium, des surfaces formant barrière particulières étant constituées d'une bicouche nitrure de tantale/tantale ou d'une couche de ruthénium.

La présente invention va maintenant être illustrée par les exemples non limitatifs suivants dans lesquels le procédé selon l'invention est utilisé pour réaliser le dépôt d'une couche de germination de cuivre sur des substrats de silicium revêtus d'une couche barrière de diffusion au cuivre. Ce procédé trouve notamment application dans la fabrication de structures d'interconnexion en cuivre pour circuits intégrés.

### EXEMPLE 1 : Préparation d'une couche de germination de cuivre sur une couche barrière TaN/Ta selon un premier mode de réalisation de l'invention.

### A. Matériel et équipement

### Substrat :

Le substrat utilisé dans cet exemple est constitué d'une plaque de silicium de 200 mm de diamètre, recouverte d'une couche de silice ayant une épaisseur de 400 nm elle-même revêtue d'une couche de nitrure de tantale (TaN) ayant une épaisseur de 15 nm déposée par pulvérisation réactive et d'une couche de tantale (Ta) ayant une épaisseur de 10 nm déposée par pulvérisation.

Cette « bi-couche » TaN/Ta constitue une barrière de diffusion au cuivre telle qu'utilisée dans les structures dites « double damascène » dans la fabrication des interconnexions en cuivre des circuits intégrés.

### Solution d'électrodéposition :

La solution d'électrodéposition mise en oeuvre dans cet exemple est une solution aqueuse contenant 0,3 g/l (ou 1,7 mM) de 2,2' bipyridine, 0,6 g/l (ou 2,4 mM) de CuSO₄(H₂O)₅ et 0,3ml/l (ou 3,3 mM) de pyridine, dont le pH est de l'ordre de 6.

### Equipement :

Dans cet exemple, on a utilisé un équipement de dépôt électrolytique représentatif de ceux employés dans l'industrie microélectronique de marque Semitool® et de type Equinox™ capable de traiter des plaques de 200 mm de diamètre.

Cet équipement comporte une cellule de dépôt électrolytique dans laquelle est réalisé le dépôt de la couche de germination et une station de rinçage/séchage utilisée après dépôt.

La cellule de dépôt électrolytique comporte une anode qui peut être constituée soit en un métal inerte (titane recouvert de platine par exemple), soit en un métal identique à celui constituant la couche de germination, en l'occurrence du cuivre ; la plaque de silicium revêtue par la couche barrière TaN/Ta, constituant la cathode de cette cellule.

Cette cellule comporte en outre une alimentation électrique stabilisée permettant de fournir jusqu'à 30 V et 4 A et un dispositif de mise en contact électrique de la cathode physiquement isolé de la solution par un joint d'étanchéité. Ce dispositif de mise en contact électrique est généralement de forme annulaire et permet une alimentation du substrat en plusieurs points de contacts disposés de manière régulière sur celui-ci.

Elle comporte également un dispositif de support de la plaque à revêtir comportant des moyens de mise en rotation de la dite plaque à vitesse prédéterminée.

### B. Protocole expérimental

Le procédé conforme à l'invention comporte les différentes étapes consécutives suivantes.

### Etape 1 : « Entrée à froid »

Cette étape peut être décomposée en deux sous étapes :
1.1. Le substrat précité est introduit dans la cellule de dépôt électrolytique de façon à ce que la face comportant la couche barrière TaN/Ta vienne au contact du dispositif de mise en contact électrique, ce dernier n'étant toujours pas alimenté électriquement.
1.2. L'ensemble formé par le dispositif de mise en contact électrique et le substrat, qui sera dénommé par la suite « ensemble cathodique » est mis en contact, par exemple par trempage, avec la solution d'électrodéposition. Cette mise en contact, dont la durée est généralement inférieure ou égale à 5 secondes (par exemple 2 secondes) est réalisée alors que le dispositif n'est toujours pas alimenté électriquement. Selon une caractéristique particulière du procédé conforme à l'invention, l'ensemble cathodique est alors maintenu dans la solution d'électrodéposition sans polarisation pendant une durée d'au moins 5 secondes (par exemple de l'ordre de 30 secondes).

### Etape 2 : Formation du revêtement de cuivre

L'ensemble cathodique est alors polarisé en mode potentiostatique en imposant une tension de cellule correspondant à un courant par unité de surface généralement compris entre 0,4 mA/cm² et 0,8 mA/cm² (par exemple 0,6 mA/cm²) et simultanément mis en rotation à une vitesse de 20 à 60 tours par minutes (40 tours par minute par exemple).

La durée de cette étape dépend, comme on le comprend, de l'épaisseur souhaitée de la couche de germination. Cette durée peut être facilement déterminée par l'homme du métier, la croissance du film étant fonction de la charge passée dans le circuit.

Dans les conditions précitées, la vitesse de dépôt est d'environ 1nm par coulomb de charge passée dans le circuit.

Dans cet exemple, la durée de l'étape d'électrodéposition a été de l'ordre de 50 secondes pour obtenir un revêtement ayant une épaisseur de 10 nm et de l'ordre de 200 secondes pour obtenir un revêtement ayant une épaisseur de 40 nm.

### Etape 3 : « Sortie à chaud »

Cette étape peut être décomposée en deux sous étapes :
3.1. Après l'étape d'électrodéposition, l'ensemble cathodique revêtu de cuivre est retiré de la solution d'électrodéposition à vitesse de rotation nulle en étant maintenu sous polarisation en tension. La durée de cette phase est d'environ 2 secondes.

La vitesse de rotation est alors portée à 500 tours par minute pendant 10 secondes, la polarisation de l'ensemble cathodique étant coupée pendant cette dernière phase.

Un pré-rinçage à l'eau dé-ionisée est effectué dans la cellule.

3.2. Le substrat revêtu de la couche de germination est alors transféré dans le module de rinçage/séchage pour subir un rinçage à l'eau dé-ionisée.

L'eau de rinçage est alors évacuée puis un séchage sous balayage d'azote est réalisé.

La rotation est alors stoppée pour permettre le retrait du substrat revêtu et séché.

Dans cet exemple, l'étape de sortie et en particulier le retrait de l'ensemble cathodique de la solution d'électrodéposition a été effectué sous polarisation en tension au même niveau que durant l'étape de formation du dépôt.

### C. Résultats obtenus

En appliquant le protocole expérimental exposé ci-dessus, on a obtenu des couches de cuivre de 10 nm, 20 nm et 40 nm d'épaisseur présentant d'excellentes caractéristiques de conformité, d'adhésion et de résistance.

La conformité a été évaluée à partir d'observations en coupe au microscope électronique à balayage et en comparant l'épaisseur de la couche de germination sur les surfaces horizontales avec celle sur les surfaces verticales.

La résistance carrée a été mesurée à l'aide d'un appareil de type mesure « 4 pointes » bien connu de l'homme du métier.

L'adhésion ou énergie d'interface a été mesurée après dépôt électrochimique d'une couche de 500 nm de cuivre (dite couche de « plating » ou couche de remplissage ou cuivre épais ou couche épaisse) sur la couche de germination. Cette mesure a été effectuée à l'aide d'un dispositif (dit machine d'essai ou de traction) qui exerce une force de tension verticale croissante sur la surface par l'intermédiaire d'un ruban adhésif puissant jusqu'à ce que la couche de cuivre (couche de germination et couche de plating) se sépare du substrat. Le travail de cette force (force multipliée par longueur de la couche qui a délaminé) équivaut à l'énergie qu'il a fallu fournir pour séparer la couche de cuivre de son substrat. En divisant cette énergie par la valeur de la surface qui a délaminé, on obtient l'énergie par unité de surface.

Une partie des résultats des mesures réalisées a été reportée dans le tableau 1 ci-dessous.

### EXEMPLE 2 : Préparation d'une couche de germination de cuivre sur une couche barrière TaN selon un deuxième mode de réalisation de l'invention.

Dans cet exemple, le procédé conforme à la présente invention est utilisé pour le dépôt d'une couche de germination de cuivre sur des barrières de diffusion ayant une forte résistivité.

### A. Matériel et équipement

### Substrat :

Le substrat utilisé dans cet exemple est constitué d'une plaque de silicium de 200 mm de diamètre, recouverte d'une couche de silice ayant une épaisseur de 400 nm elle-même revêtue d'une couche de nitrure de tantale (TaN) ayant une épaisseur de 5 nm déposée par la technique dite ALD (en anglais « atomic layer déposition »).

Cette couche TaN constituant une barrière de diffusion au cuivre telle qu'utilisée dans les structures dites « double damascène » pour les interconnexions en cuivre des circuits intégrés présente une résistance de couche de l'ordre de 3500 ohm/carré.

Cette plaque est ensuite découpée en pièces rectangulaires de 1,5 cm de largeur et 6 cm de longueur ci-après dénommées « échantillons ».

### Solution d'électrodéposition :

La solution mise en oeuvre dans cet exemple est une solution aqueuse contenant 0,3 g/l (ou 1,7 mM) de 2,2' bipyridine, 0,6 g/l (ou 2,4 mM) de CuSO₄(H₂O)₅ et 0,3ml/l (ou 3,3 mM) de pyridine, dont le pH est de l'ordre de 6.

### Equipement :

Dans cet exemple, on a utilisé une cellule en verre dans laquelle 100ml de la solution d'électrodéposition précitée ont été introduits.

Cette cellule est munie d'un couvercle comportant deux ouvertures débouchant dans deux enceintes dans lesquelles sont fixés d'une part un porte-échantillon et son dispositif de mise en contact électrique et d'autre part l'anode constituée d'une pièce de titane platiné.

Le dispositif de mise en contact électrique et l'anode sont reliés à un potentiostat capable de délivrer 20 V et 2 A.

### B. Protocole expérimental

Le procédé conforme à l'invention comporte les différentes étapes consécutives suivantes.

### Etape 1 : « Entrée à froid »

Cette étape peut être décomposée en deux sous étapes :
1.1. Chaque échantillon est introduit dans la cellule de dépôt électrolytique de façon à ce que la face comportant la couche barrière TaN vienne au contact du dispositif de mise en contact électrique, ce dernier n'étant toujours pas alimenté électriquement.
1.2. L'ensemble formé par dispositif de mise en contact électrique et le substrat, qui sera dénommé par la suite « ensemble cathodique » est mis en contact, par exemple par trempage, avec la solution d'électrodéposition. Cette mise en contact, dont la durée est généralement inférieure ou égale à 5 secondes (par exemple 2 secondes) est réalisée alors que le dispositif n'est toujours pas alimenté électriquement. Selon une caractéristique particulière du procédé conforme à l'invention, l'ensemble cathodique est alors maintenu dans la solution d'électrodéposition sans polarisation pendant une durée supérieure à 5 secondes (par exemple 30 secondes).

### Etape 2 : Formation du revêtement de cuivre

L'ensemble cathodique est alors polarisé en tension de manière à imposer des créneaux de tension de cellule ayant un maximum de 8 V à 12 V (par exemple 10 V) et un minimum entre 0 V et 2 V (par exemple 1 V).

La durée de polarisation à 10 V est comprise entre 0,1 et 5 secondes (par exemple 2 secondes).

La durée de polarisation à 1 V est comprise entre 0,15 et 7 secondes (par exemple 3 secondes).

Dans un exemple spécifique, chaque cycle de mise sous tension est donc constitué d'une polarisation de 2 secondes à 10 V suivie d'une polarisation de 3 secondes à 1 V.

Dans ces conditions expérimentales, la vitesse de dépôt est d'environ 0,32 nm par cycle et on a ainsi réalisé 200 cycles pour obtenir un revêtement de cuivre ayant une épaisseur de 65 nm.

### Etape 3 : « Sortie à chaud »

L'ensemble cathodique est alors retiré verticalement de la solution toujours sous polarisation en tension à 10 V.

Chaque échantillon est ensuite rincé manuellement à l'eau dé-ionisée pendant 30 secondes et séché au pistolet à Argon pendant 30 secondes.

### C. Résultats obtenus

Dans l'exemple précis défini ci-dessus, on a obtenu une couche de germination de cuivre présentant une résistance carrée de 0,5 ohm/carré.

Une couche de cuivre de remplissage a pu être déposée électrochimiquement sur cette couche.

L'ensemble couche de germination/couche de remplissage présente une énergie d'interface de l'ordre 6 J/m² mesurée par la technique décrite à l'exemple 1.

Le protocole précité a été également mis en oeuvre avec des échantillons provenant de plaques de silicium recouvertes de couches barrières présentant des résistivités élevées variant entre 200 micro-ohm.cm et 50000 micro-ohm.cm (soit entre 400 et 100000 ohm/carré).

De bons résultats ont été obtenus en termes de conformité, d'adhésion et de résistance.

### EXEMPLE 3 : Préparation d'une couche de germination de cuivre sur une couche barrière Ru selon un troisième mode de réalisation de l'invention.

Dans cet exemple, le procédé conforme à la présente invention est utilisé pour le dépôt d'une couche de germination de cuivre sur une barrière de diffusion à base de ruthénium.

### Substrat :

Le substrat utilisé dans cet exemple est constitué d'un coupon de silicium ayant une longueur de 6 cm et une largeur de 2 cm, recouvert d'une couche de silice ayant une épaisseur de 400 nm elle-même revêtue d'une couche de ruthénium (Ru) ayant une épaisseur de 30 nm déposée par pulvérisation. La résistance carré de ce substrat est de 7,5 ohm/carré.

Cette couche de Ru peut constituer une barrière de diffusion au cuivre telle qu'utilisée dans les structures dites "double damascène" dans la fabrication des interconnexions en couvre des circuits intégrés avancés.

### Solution :

La solution mise en oeuvre dans cet exemple est identique à celle de l'exemple 1.

### Equipement :

Dans cet exemple, on utilise une cellule de dépôt éléctrolytique en verre composée de deux parties : la cellule destinée à contenir la solution d'électrodéposition, et un « capot » qui permet de maintenir les différentes électrodes en position d'utilisation.

La cellule de dépôt électrolytique comporte trois électrodes :
- une anode en métal inerte (platine),
- le coupon de silicium revêtu de la couche TaN/Ta, qui constitue la cathode,
- une électrode de référence Ag/AgClO₄.
Des connecteurs permettent la mise en contact électrique des électrodes qui sont reliés par des fils électriques à un potentiostat fournissant jusqu'à 10 V et 2 A.

### B. Protocole expérimental

Le procédé d'électrodéposition mis en oeuvre dans cet exemple comporte les différentes étapes consécutives suivantes.

### Etape 1 : « Entrée à froid »

La solution d'électrodéposition est versée dans la cellule.

On met en place les différentes électrodes sur le capot de la cellule électrolytique.

Les électrodes sont mises en contact avec la solution d'électrodéposition. A ce stade, l'ensemble ainsi formé n'est toujours pas polarisé électriquement (il est à son potentiel de circuit ouvert).

L'ensemble est maintenu dans cet état (c'est-à-dire sans polarisation électrique) pendant une durée de 10 à 60 secondes (par exemple 30 secondes).

### Etape 2 : Formation du revêtement de cuivre

La cathode est polarisée en mode galvanostatique dans une gamme de courant de 2 mA (ou 0,25 mA/cm²) à 8 mA (ou 1 mA/cm²) (par exemple 6 mA (ou 0,75 mA/cm²)).

Un dégazage à l'argon peut être employé ; il permet d'avoir une certaine hydrodynamique dans la cellule.

La durée de cette étape dépend de l'épaisseur souhaitée de la couche de germination et peut être facilement déterminée par l'homme du métier, la croissance du film étant fonction de la charge passée dans le circuit.

Dans les conditions précitées, la vitesse de dépôt est d'environ 33 nm par coulomb de charge passée dans le circuit.

Dans cet exemple, la durée de l'étape d'électrodéposition a été de l'ordre de 200 secondes pour obtenir un revêtement ayant une épaisseur de l'ordre de 40 nm.

### Etape 3 : « Sortie à chaud »

La cathode est alors séparée de la solution, la polarisation étant toujours appliquée.

La cathode est alors déconnectée, et rincée abondamment à l'eau dé-ionisée 18 MΩ, puis séchée à l'aide d'un pistolet délivrant de l'argon à une pression de l'ordre de 2 bars.

### C. Résultats obtenus

En appliquant le protocole expérimental décrit ci-dessus on a obtenu une couche de cuivre continue et conforme (observation au microscope électronique à balayage) de 40 nm d'épaisseur.

Cette couche de germination de cuivre présente une résistance carrée de 2,5 ohm/carré, mesurée par la méthode décrite à l'exemple 1.

### EXEMPLE 4 : Préparation d'une couche de germination de cuivre sur une couche barrière TaN/Ta selon un quatrième mode de réalisation de l'invention.

### A. Matériel et équipement

### Substrat :

Le substrat utilisé dans cet exemple est identique à celui utilisé à l'exemple 1.

### Solution d'électrodéposition :

La solution d'électrodéposition mise en oeuvre dans cet exemple est une solution aqueuse (eau dé-ionisée18,2 Mohm.cm) préparée en salle propre (classe 10000 ou ISO 7) contenant 0,4 g/l (ou 2,56 mM) de 2,2' bipyridine de pureté 99,7% commercialisé par la société Oxkem, 0,8 g/l (ou 3,2 mM) de CuSO₄(H₂O)₅ de pureté 99,995% commercialisé par la société Alfa Aesar et 0,367 ml/l (ou 4 mM) de pyridine de pureté 99,9 % commercialisée par la société Aldrich.

La solution est filtrée à l'aide d'un filtre de taille 0,2 µm après sa fabrication.

Le pH de la solution est 5,94.

### Equipement :

L'équipement utilisé dans cet exemple est identique à celui utilisé à l'exemple 1.

### B. Protocole expérimental

Le procédé d'électrodéposition mis en oeuvre dans cet exemple est identique à celui de l'exemple 1.

### C. Résultats obtenus

En appliquant le protocole expérimental exposé ci-dessus, on a obtenu des couches de cuivre de 10 nm et 20 nm d'épaisseur présentant d'excellentes caractéristiques de conformité, d'adhésion et de résistance.

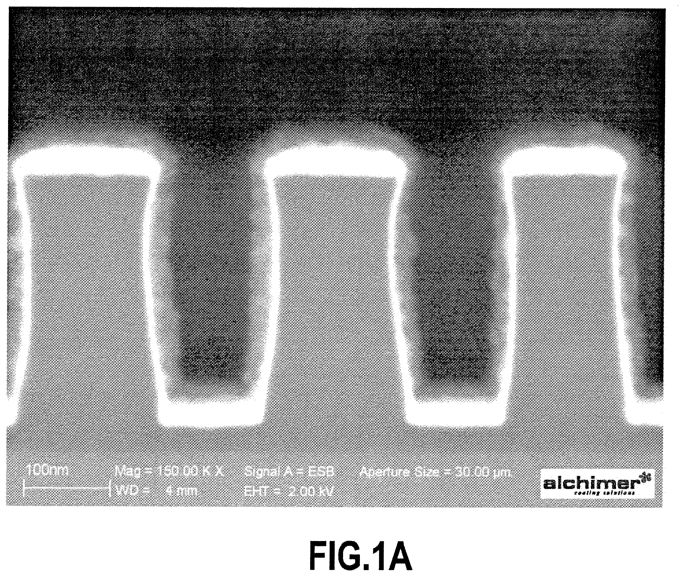

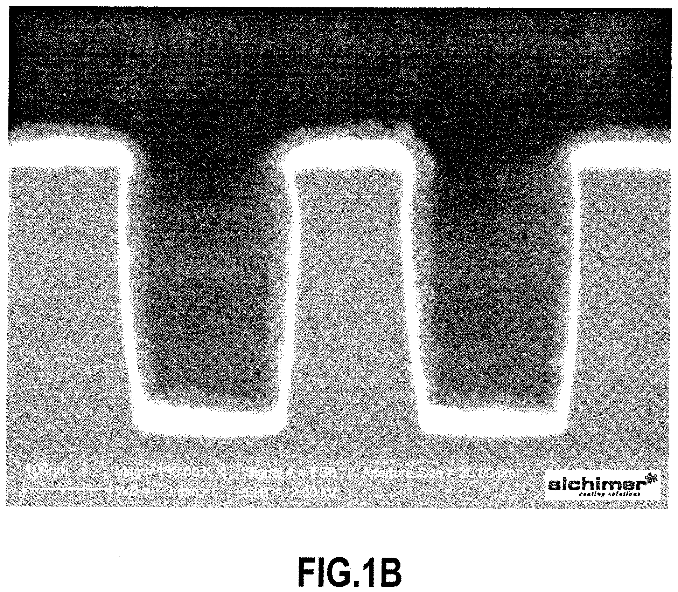

Les excellentes caractéristiques de conformité de ce revêtement sont illustrées par les figures 1a et 1b qui représentent une vue en coupe en imagerie d'électrons rétrodiffusés permettant de visualiser le contraste chimique.

La conformité sur tranchées a aussi été caractérisée à plus grande échelle (0,01 mm²) par scattérométrie. Ces mesures nt montré une épaisseur de cuivre sur le haut, le bas et les flancs des tranchées de 7 nm, en accord avec les épaisseurs observées en coupe MEB.

Hormis la scattérométrie, les méthodes de caractérisation utilisées dans cet exemple sont identiques à celles de l'exemple 1.

Le tableau 1 ci-dessous rassemble quelques résultats obtenus par la mise en oeuvre des exemples 1 à 4 décrits précédemment. Plus précisément, on a reporté dans ce tableau les valeurs de résistance carrée et d'adhésion (mesurées selon les protocoles indiqués à l'exemple 1) obtenues pour des couches de germination de cuivre d'épaisseurs variables. Des tendances similaires sont également observées pour une résistance carrée avant traitement pouvant être de plusieurs centaines d'ohm/carré, voire plusieurs dizaines de milliers d'ohm/carré, voire encore jusqu'à quelques méga ohm/carré.

A titre comparatif, on a également reporté dans ce tableau les valeurs de résistance carrée et d'adhésion obtenues à l'aide des compositions spécifiquement utilisées dans le cadre de l'invention en appliquant un procédé d'électrodéposition usuel comportant une entrée à chaud et une sortie à froid.

**TABLEAU 1**

| Couche de germination de cuivre obtenue selon | Epaisseur (nm) | Résistance carrée (ohm/carré) | | Adhésion (J/m²) |
|---|---|---|---|---|
| | | Avant traitement | Après traitement | |
| Exemple comparatif | 20 | 23 | 18 | 5 |
| Exemple 1 | 20 | 23 | 8 | 11-13 |
| Exemple 1 | 10 | 23 | 18 | 11-13 |
| Exemple 2 | 65 | 3 500 | 0,5 | 6 |
| Exemple 3 | 40 | 7,5 | 2,5 | > 20 |
| Exemple 4 | 20 | 22 | 5,3 | > 20 |
| Exemple 4 | 10 | 21 | 15 | >20 |

Les observations réalisées sur des vues en coupe au microscope électronique à balayage ont montré que les couches de germination de cuivre obtenues par la mise en oeuvre du procédé conforme à l'invention sont uniformes et continues et satisfont pleinement aux exigences de conformité requises.

Les résultats ainsi obtenus montrent en outre que le procédé conforme à l'invention permet notamment de réaliser des couches de germination en cuivre continues et conformes, pouvant présenter une épaisseur de l'ordre de 10 nm ou moins et présentant une excellente adhésion sur des surfaces de barrière de diffusion.

Le tableau 1 montre en particulier que les films de germination de cuivre présentent une résistance carrée très inférieure à celle de la surface du substrat, cette résistance carrée étant d'autant plus faible que l'épaisseur de la couche de germination est importante.

Les couches de germination de cuivre obtenues sont suffisamment conductrices (résistance carrée suffisamment faible) pour permettre un remplissage ultérieur par électrodéposition classique, y compris lorsque l'épaisseur de la couche de germination de cuivre est très faible, comme par exemple de l'ordre de 10 nm ou moins.

Les valeurs d'adhésion mesurées sont au moins égales voire supérieures à celles qui seraient attendues par un homme du métier dans le cadre de la mise en oeuvre d'un procédé de pulvérisation.

Ces résultats montrent donc que le procédé conforme à l'invention permet bien de résoudre le problème technique posé.

## Revendications

1. Procédé de revêtement par électrodéposition d'une surface d'un substrat par une couche de germination de cuivre ayant une épaisseur de l'ordre de 10 nm ou moins, ledit substrat étant une couche barrière de diffusion du cuivre, **caractérisé en ce qu'**il comprend :
- une étape dite d'« entrée à froid » au cours de laquelle ladite surface à revêtir est mise en contact sans polarisation électrique avec un bain d'électrodéposition pendant une durée d'au moins 5 secondes;
- une étape de formation du revêtement dans le bain d'électrodéposition au cours de laquelle ladite surface est polarisée pendant une durée suffisante pour former ledit revêtement ;
- une étape dite de « sortie à chaud » au cours de laquelle ladite surface est séparée du bain d'électrodéposition sous polarisation électrique ; et **en ce que** le bain d'électrodéposition précité comprend en solution dans un solvant :
- une source d'ions du cuivre, en une concentration comprise entre 0,4 et 40 mM, de préférence entre 0,4 et 18 mM et de préférence encore entre 0,4 et 15 mM ;
- un mélange de pyridine et de 2,2' bipyridine en tant qu'agents complexants du cuivre,
- le pH de ladite composition étant inférieur à 7.

2. Procédé selon la revendication 1, **caractérisé en ce que** l'étape de formation du revêtement précitée est réalisée par polarisation en mode galvanostatique, de préférence dans une gamme de courant de 0,1 mA/cm² (milli-Ampère par centimètre carré) à 5 mA/cm², et plus particulièrement de 0,1 mA/cm² à 1 mA/cm².

3. Procédé selon la revendication 1, **caractérisé en ce que** l'étape de formation du revêtement précitée est réalisée par polarisation en mode potentiostatique, en imposant une tension de cellule de préférence de manière à ce que le courant de cellule résultant soit dans une gamme de 0,1 mA/cm² à 5 mA/cm², et plus particulièrement de 0,1 mA/cm² à 1 mA/cm².

4. Procédé selon la revendication 1, **caractérisé en ce que** l'étape de formation du revêtement précitée est réalisée par polarisation en mode pulsé, de préférence de manière à imposer des créneaux de tension correspondants à un courant cathodique par unité de surface maximum dans une gamme de 0,1 mA/cm² à 5 mA/cm², et plus particulièrement de 0,1 mA/cm² à 1 mA/cm² et à un courant cathodique par unité de surface minimum dans une gamme de 0 mA/cm² à 0,5 mA/cm², et plus particulièrement de 0 mA/cm² à 0,1 mA/cm².

5. Procédé selon l'une des revendications 1 à 4, **caractérisé en ce que** au cours de l'étape d'« entrée à froid », la surface à revêtir est maintenue au contact du bain d'électrodéposition pendant une durée comprise entre 10 et 60 secondes, de préférence pendant une durée d'environ 10 à 30 secondes.

6. Procédé selon l'une des revendications 1 à 5, **caractérisé en ce que** le substrat précité est une plaque de silicium en cours de fabrication de circuits intégrés dont la surface, surface à revêtir, est celle d'une couche de barrière de diffusion au cuivre telle qu'une bi-couche à base de nitrure de tantale et de tantale (TaN/Ta) ou une couche de nitrure de tantale seul (TaN).

7. Procédé selon l'une des revendications 1 à 6, **caractérisé en ce que** au cours de l'étape de « sortie à chaud », la surface revêtue est séparée sous polarisation du bain d'électrodéposition pendant une durée comprise entre 1 et 10 secondes, de préférence pendant une durée d'environ 1 à 5 secondes.

8. Procédé selon l'une des revendications 1 à 7, **caractérisé en ce que** dans le bain d'électrodéposition précité le rapport molaire entre le cuivre et les agents complexants est compris entre 0,1 et 2,5 ; de préférence entre 0,3 et 1,3 ; et
- le pH de ladite composition est compris entre 3,5 et 6,5.

9. Procédé selon l'une des revendications 1 à 8, **caractérisé en ce que** dans le bain d'électrodéposition précité le solvant précité est choisi parmi l'eau et les solutions hydroalcooliques et la source d'ions du cuivre est un sel de cuivre tel qu'en particulier le sulfate de cuivre, le chlorure de cuivre, le nitrate de cuivre, l'acétate de cuivre, de préférence le sulfate de cuivre.

10. Procédé selon la revendication 1 à 9, **caractérisé en ce que** le pH de la composition est compris entre 3,5 et 6,5.

## Patentansprüche

1. Verfahren zum Elektroplattierungsbeschichten einer Substratoberfläche mit einer Kupferkeimschicht, die eine Dicke von etwa 10 nm oder weniger aufweist, wobei es sich bei dem Substrat um eine Kupferdiffusionsbarriereschicht handelt, **dadurch gekennzeichnet, dass** es umfasst:
- einen sogenannten "Kalteintritts"-Schritt, bei dem die zu beschichtende Oberfläche ohne elektrische Polarisation für einen Zeitraum von mindestens 5 Sekunden mit einem Elektroplattierbad in Kontakt gebracht wird,
- einen Schritt zum Bilden der Beschichtung in dem Elektroplattierbad, bei dem die Oberfläche für eine ausreichende Zeit polarisiert wird, um die Beschichtung zu bilden,
- einen sogenannten "Heißaustritts"-Schritt, bei dem die Oberfläche unter elektrischer Polarisation vom Elektroplattierbad getrennt wird, und dadurch, dass das vorstehend genannte Elektroplattierbad das Folgende in Lösung in einem Lösungsmittel umfasst:
- eine Kupferionenquelle in einer Konzentration zwischen 0,4 und 40 mM, bevorzugt zwischen 0,4 und 18 mM und noch bevorzugter zwischen 0,4 und 15 mM,
- eine Mischung aus Pyridin und 2,2' Bipyridin als Kupferkomplexbildner,
- wobei der pH-Wert der Zusammensetzung kleiner als 7 ist.

2. Verfahren nach Anspruch 1, **dadurch gekennzeichnet, dass** der Schritt zum Bilden der Beschichtung durch Polarisation im galvanostatischen Modus durchgeführt wird, vorzugsweise in einem Strombereich von 0,1 mA/cm² (Milliampere pro Quadratzentimeter) bis 5 mA/cm², insbesondere von 0,1 mA/cm² bis 1 mA/cm².

3. Verfahren nach Anspruch 1, **dadurch gekennzeichnet, dass** der Schritt zum Bilden der Beschichtung durch Polarisation im potentiostatischen Modus durchgeführt wird, indem eine Zellenspannung vorzugsweise so angelegt wird, dass der resultierende Zellenstrom in einem Bereich von 0,1 mA/cm² bis 5 mA/cm² und insbesondere von 0,1 mA/cm² bis 1 mA/cm² liegt.

4. Verfahren nach Anspruch 1, **dadurch gekennzeichnet, dass** der Schritt zum Bilden der Beschichtung durch Polarisation im gepulsten Modus durchgeführt wird, vorzugsweise in einer Weise, dass Spannungsschlitze auferlegt werden, die einem maximalen Kathodenstrom pro Oberflächeneinheit in einem Bereich von 0,1 mA/cm² bis 5 mA/cm², insbesondere von 0,1 mA/cm² bis 1 mA/cm², und einem minimalen Kathodenstrom pro Oberflächeneinheit in einem Bereich von 0 mA/cm² bis 0,5 mA/cm², insbesondere von 0 mA/cm² bis 0,1 mA/cm², entsprechen.

5. Verfahren nach einem der Ansprüche 1 bis 4, **dadurch gekennzeichnet, dass** im "Kalteintritts"-Schritt die zu beschichtende Oberfläche für einen Zeitraum von 10 bis 60 Sekunden, vorzugsweise für einen Zeitraum von etwa 10 bis 30 Sekunden, in Kontakt mit dem Elektroplattierbad gehalten wird.

6. Verfahren nach einem der Ansprüche 1 bis 5, **dadurch gekennzeichnet, dass** es sich bei dem vorgenannten Substrat um einen Siliziumwafer bei der Herstellung von integrierten Schaltungen handelt, bei welchem die Oberfläche, die zu beschichten ist, die Oberfläche einer Kupferdiffusionsbarriereschicht ist, wie beispielsweise eine Doppelschicht auf Basis von Tantalnitrid und Tantal (TaN/Ta) oder eine einzelne Tantalnitridschicht (TaN).

7. Verfahren nach einem der Ansprüche 1 bis 6, **dadurch gekennzeichnet, dass** im "Heißaustritts"-Schritt die beschichtete Oberfläche unter Polarisation vom Elektroplattierbad für einen Zeitraum von 1 bis 10 Sekunden, vorzugsweise für einen Zeitraum von etwa 1 bis 5 Sekunden, getrennt wird.

8. Verfahren nach einem der Ansprüche 1 bis 7, **dadurch gekennzeichnet, dass** im Elektroplattierbad das Molverhältnis zwischen Kupfer und Komplexbildnern zwischen 0,1 und 2,5, vorzugsweise zwischen 0,3 und 1,3 liegt und
- der pH-Wert der Zusammensetzung zwischen 3,5 und 6,5 liegt.

9. Verfahren nach einem der Ansprüche 1 bis 8, **dadurch gekennzeichnet, dass** im Elektroplattierbad das Lösungsmittel aus Wasser und hydroalkoholischen Lösungen ausgewählt ist und die Kupferionenquelle ein Kupfersalz wie insbesondere Kupfersulfat, Kupferchlorid, Kupfernitrat, Kupferacetat ist, vorzugsweise Kupfersulfat.

10. Verfahren nach Anspruch 1 bis 9, **dadurch gekennzeichnet, dass** der pH-Wert der Zusammensetzung zwischen 3,5 und 6,5 liegt.

## Claims

1. Method of coating a surface of a substrate with a copper seed layer having a thickness of about 10 nm or less, by electroplating, said substrate being a copper diffusion barrier layer, **characterized in that** it comprises:
- a step referred to as "cold entry" during which the said surface to be coated is brought into contact with an electroplating bath while the said surface is not under electrical bias for at least 5 seconds;
- a step of forming the coating in the electroplating bath during which the said surface is biased for a time long enough to form the said coating;
- a step referred to as "hot exit" during which the said surface is separated from the electroplating bath under electrical bias; and **in that** the aforementioned electroplating bath comprises, in solution in a solvent:
- a source of copper ions, with a concentration of between 0.4 and 40mM, preferably of between 0.4 and 18 mM and more preferably of between 0.4 and 15 mM;
- a mixture of pyridine and 2,2'-bipyridine as copper complexing agents;
- the pH of said composition being less than 7.

2. Method according to Claim 1, **characterized in that** the aforementioned step of forming the coating is carried out by biasing in galvanostatic mode, preferably within the current range from 0.1 mA/cm² (milliamps per square centimetre) to 5 mA/cm², and more particularly from 0.1 mA/cm² to 1 mA/cm².

3. Method according to Claim 1, **characterized in that** the aforementioned step of forming the coating is carried out by biasing in potentiostatic mode, preferably imposing a cell voltage so that the resulting cell current lies within the 0.1 mA/cm² to 5 mA/cm² range, and more particularly the 0.1 mA/cm² to 1 mA/cm² range.

4. Method according to Claim 1, **characterized in that** the aforementioned step of forming the coating is carried out by biasing in pulsed mode, preferably so as to impose voltage pulses corresponding to a maximum cathode current per unit area within the range from 0.1 mA/cm² to 5 mA/cm², and more particularly from 0.1 mA/cm² to 1 mA/cm², and to a minimum cathode current per unit area within the range from 0 mA/cm² to 0.5 mA/cm², and more particularly from 0 mA/cm² to 0.1 mA/cm².

5. Method according to one of Claims 1 to 4, **characterized in that**, during the "cold entry" step, the surface to be coated is maintained in contact with the electroplating bath for a period of between 10 and 60 seconds, preferably for a period of about 10 to 30 seconds.

6. Method according to one of Claims 1 to 5, **characterized in that** the aforementioned substrate is a silicon wafer in the course of fabricating integrated circuits, the surface of which, to be coated, is that of a copper diffusion barrier layer, such as a bilayer based on tantalum nitride/tantalum (TaN/Ta) or just a tantalum nitride (TaN) layer.

7. Method according to one of Claims 1 to 6, **characterized in that**, during the "hot exit" step, the coated surface is withdrawn from the electroplating bath while under bias for a period of between 1 and 10 seconds, preferably for a period of about 1 to 5 seconds.

8. Method according to one of Claims 1 to 7, **characterized in that**, in the aforementioned electroplating bath:
- the copper/complexing agent(s) molar ratio is between 0.1 and 2.5, preferably between 0.3 and 1.3; and
- the pH of the said composition being between 3.5 and 6.5.

9. Method according to one of Claims 1 to 8, **characterized in that**, in the aforementioned electroplating bath, the aforementioned solvent is chosen from water and hydroalcoholic mixtures and the source of copper ions is a copper salt, such as in particular copper sulphate, copper chloride, copper nitrate or copper acetate, preferably copper sulphate.

10. Method according to one of Claims 1 to 9, **characterized in that** the pH of the said composition is between 3.5 and 6.5.
